# EUROPEAN PATENT APPLICATION

(11) **EP 3 889 838 A1**
(43) Date of publication of application: **06.10.2021**
(21) Application number: 19889371.1
(22) Date of filing: 22.11.2019
(51) Int. Cl.: G06K 19/077, G06K 19/07, H01Q 13/08, H01Q 9/04, H01Q 9/16, H01Q 1/38

(54) **RFID TAG**

(30) Priority: 29.11.2018 JP 2018222953; 27.02.2019 JP 2019033429
(71) Applicant: Kyocera Corporation, Kyoto-shi, Kyoto 612-8501 (JP)
(72) Inventor: YAMAMOTO, Shuichi, Kyoto-shi, Kyoto 612-8501 (JP); HAYASHI, Takuya, Kyoto-shi, Kyoto 612-8501 (JP)
(74) Representative: Viering, Jentschura & Partner mbB Patent- und Rechtsanwälte
(86) International application number: PCT/JP2019/045757
(87) International publication number: WO 2020/110930

(57) **Abstract**

The present invention provides an RFID tag with which it is possible to extend a communicatable distance by a simple and highly reliable antenna connection. This RFID tag (1) comprises an RFID tag device (20) created by mounting an IC for RFID tags on a substrate, and a sheet antenna (10) which includes an antenna conductor (12) and to which the RFID tag device is secured. The substrate of the RFID tag device (20) has a first surface conductor, a second surface conductor arranged between the first surface conductor and the antenna conductor, and a short-circuit conductor for short-circuiting the first surface conductor and the second surface conductor together, the direction of the second surface conductor that faces the center of the second surface conductor from the connecting part of the short-circuit conductor facing the longitudinal direction (X0) of the antenna conductor.

## Description

### Technical Field

The present disclosure relates to an RFID (Radio Frequency Identifier) tag.

### Background Art

There has been an RFID tag configured by mounting an RFID tag IC (Integrated Circuit) on a seat antenna. In WO 2009/142114 A1, there is disclosed an RFID tag in which an RFID tag IC is mounted on an antenna (radiation plate) via a power supply circuit board having a power supply circuit.

### Summary of Invention

### Solution to Problem

An RFID tag according to the present disclosure includes:
an RFID tag device including an RFID tag IC and a board where the RFID tag IC is mounted; and
a seat antenna to which the RFID tag device is fixed, the seat antenna including an antenna conductor,
wherein the board includes:
   a first surface conductor;
   a second surface conductor disposed between the first surface conductor and the antenna conductor; and
   a short-circuit conductor short-circuiting the first surface conductor and the second surface conductor, and
wherein a direction from a connection part in the second surface conductor with the short-circuit conductor to a center of the second surface conductor is aligned with a long side direction of the antenna conductor.

An RFID tag of another aspect according to the present disclosure includes:
an RFID tag device including an RFID tag IC and a board where the RFID tag IC is mounted; and
an antenna conductor,
wherein the board includes:
   a first surface conductor disposed opposite the antenna conductor;
   a second surface conductor that faces the antenna conductor; and
   a short-circuit conductor that short-circuits the first surface conductor and the second surface conductor, and
wherein when the RFID tag is viewed in a direction in which the second surface conductor and the antenna conductor face one another, a position of a node of a resonant radio wave voltage on the antenna conductor is located opposite the short-circuit conductor across a center of the second surface conductor.

### Advantageous Effects of Invention

According to the present disclosure, an effect of extending a communicable distance by simple and highly reliable antenna connection can be obtained.

### Brief Description of Drawings

FIG. 1A is a perspective view showing a first example of an RFID tag of embodiments according to the present disclosure.
FIG. 1B is a perspective view showing a second example of the RFID tag of the embodiments according to the present disclosure.
FIG. 2 is a vertical sectional view showing a first example of a representative RFID tag device.
FIG. 3 is an exploded perspective view of the RFID tag device shown in FIG. 2.
FIG. 4 is a vertical sectional view showing a second example of a representative RFID tag device.
FIG. 5 is a vertical sectional view showing a third example of a representative RFID tag device.
FIG. 6 is an exploded perspective view of the RFID tag device shown in FIG. 5.
FIG. 7 is a vertical sectional view showing a fourth example of a representative RFID tag device.
FIG. 8 is a bottom view of an RFID tag device included in an RFID tag according to a first embodiment.
FIG. 9 is a bottom view of an RFID tag device included in an RFID tag according to a second embodiment.
FIG. 10A is a vertical sectional view showing an RFID tag according to a third embodiment.
FIG. 10B is a vertical sectional view showing a comparative example against the RFID tag according to the third embodiment.
FIG. 11A is a vertical sectional view showing an RFID tag according to a fourth embodiment.
FIG. 11B is a vertical sectional view showing a comparative example against the RFID tag according to the fourth embodiment.
FIG. 12A is a vertical sectional view showing an RFID tag according to a fifth embodiment.
FIG. 12B is a vertical sectional view showing a comparative example against the RFID tag according to the fifth embodiment.
FIG. 13A is a vertical sectional view showing an RFID tag according to a sixth embodiment.
FIG. 13B is a vertical sectional view showing a comparative example against the RFID tag according to the sixth embodiment.
FIG. 14A is a vertical sectional view showing an RFID tag according to a seventh embodiment.
FIG. 14B is a vertical sectional view showing a comparative example against the RFID tag according to the seventh embodiment.
FIG. 15 is a plan view showing an RFID tag according to an eighth embodiment.
FIG. 16 is a graph showing a relationship between the wiring width of an antenna conductor and antenna gain.
FIG. 17 is a vertical sectional view showing an RFID tag according to a ninth embodiment.
FIG. 18A shows an RFID tag according to a tenth embodiment.
FIG. 18B is an enlarged view of an area C1 shown in FIG 18A.
FIG. 19 is a graph showing a relationship between the position of the RFID tag device and the antenna gain.
FIG. 20A shows a first reference example of an RFID tag device.
FIG. 20B shows field intensity at an end opposite a short-circuit conductor in the RFID tag device of the first reference example.
FIG. 21A shows a second reference example of an RFID tag device.
FIG. 21B shows the field intensity at the end opposite the short-circuit conductor in the RFID tag device of the second reference example.
FIG. 22A shows a third reference example of an RFID tag device.
FIG. 22B shows the field intensity at the end opposite the short-circuit conductor in the RFID tag device of the third reference example.
FIG. 23 shows an RFID tag according to an eleventh embodiment.

### Description of Embodiments

Hereinafter, embodiments according to the present disclosure will be described in detail with reference to the drawings.

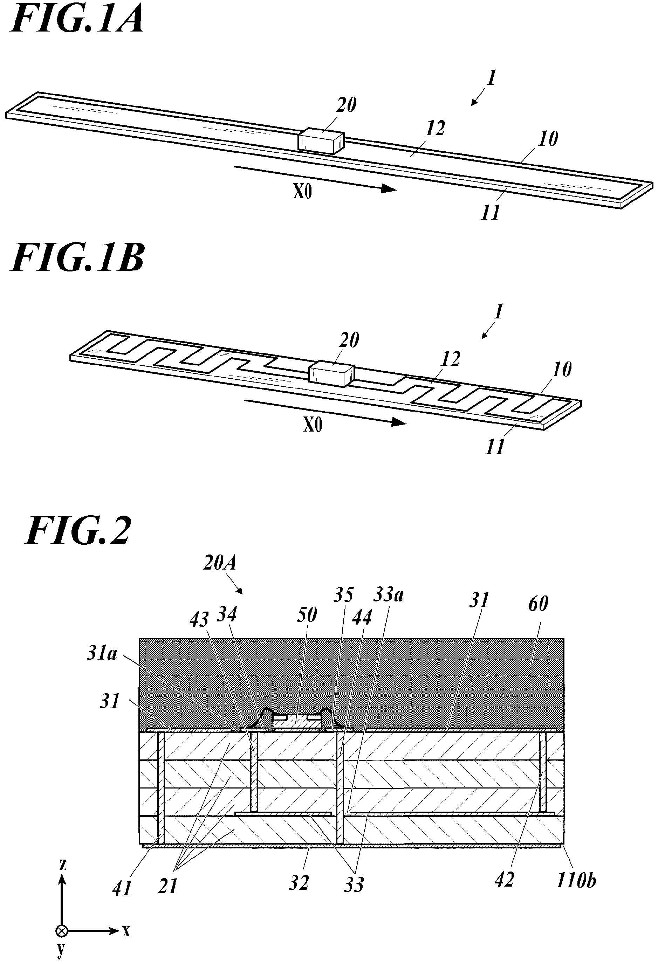

FIG. 1A is a perspective view showing a first example of an RFID tag of embodiments according to the present disclosure. FIG. 1B is a perspective view showing a second example of the RFID tag of the embodiments according to the present disclosure.

As shown in FIG. 1A, an RFID tag 1 of the embodiments includes a seat antenna 10 and an RFID tag device 20. The sheet antenna 10 includes a sheet 11 and a film-shaped antenna conductor 12 located on the sheet 11. The antenna conductor 12 is film-shaped and long along one side. As shown in FIG. 1B, the antenna conductor 12 may be meandering. The length of the antenna conductor 12 in a long side direction may be adjusted to a half wavelength of a radio signal(s), or to a length different therefrom.

The RFID tag device 20 is configured by mounting an RFID tag IC 50 (FIG. 2 to FIG. 7) on a board, and performs wireless communications with a reader/writer by receiving electric power from the reader/writer via radio waves. Although not particularly limited, the RFID tag device 20 performs wireless communications by using radio waves of UHF (Ultra High Frequency) band.

As the RFID tag device 20, there are various applicable forms that are different from one another in shape of an insulating substrate, in patterns and positions of conductors on and in the insulating substrate, for example. Representative four types of these will be described. In the following description, directions may be expressed by using the orthogonal coordinate system xyz fixedly defined for RFID tag devices 20A to 20D. Each of the RFID tag devices 20A to 20D excluding the RFID tag IC 50 corresponds to an example of the board according to the present invention.

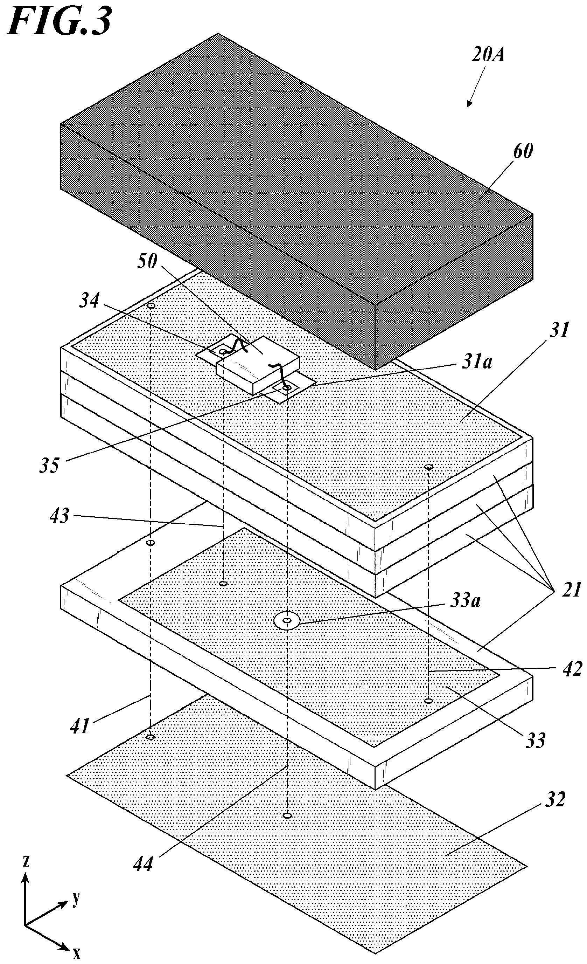

FIG. 2 is a vertical sectional view showing a first example of a representative RFID tag device. FIG. 3 is an exploded perspective view of the RFID tag device shown in FIG. 2. In FIG. 3, a short-circuit conductor 41, a capacitance connection conductor 42 and connection conductors 43, 44 are represented by chain lines.

An RFID tag device 20A of the first example includes: an insulating substrate 21 having a first surface and a second surface on the opposite side and extending in the x and y directions; a first surface conductor 31 disposed on the first surface of the insulating substrate 21; a second surface conductor 32 disposed on the second surface of the insulating substrate 21; and a capacitance sheet conductor 33 located inside the insulating substrate 21. The capacitance sheet conductor 33 is a sheet conductor extending in the x and y directions as with the first surface conductor 31 and the second surface conductor 32. The first surface conductor 31 has a through hole 31a. In the through hole 31a, two electrode pads 34, 35 that are connected to terminals of the RFID tag IC 50 are disposed. On the first surface of the insulating substrate 21, the RFID tag IC 50 is mounted, and its two terminals are connected to the electrode pads 34, 35 via bonding wires or the like. On the first surface of the insulating substrate 21, a molded resin 60 is disposed, and the first surface conductor 31 and the RFID tag IC 50 are embedded in the molded resin 60.

The RFID tag device 20A further includes the short-circuit conductor 41, the capacitance connection conductor 42 and the connection conductors 43, 44 located inside the insulating substrate 21 and each extending in the z direction. The short-circuit conductor 41 is connected to the first surface conductor 31 and the second surface conductor 32 to short-circuit these. The capacitance connection conductor 42 is connected to the first surface conductor 31 and the capacitance sheet conductor 33 to electrically connect these. The connection conductor 43 electrically connects the electrode pad 34 and the capacitance sheet conductor 33. The connection conductor 44 electrically connects the electrode pad 35 and the second surface conductor 32. The connection conductor 44 passes through a through hole 33a of the capacitance sheet conductor 33, and does not contact the capacitance sheet conductor 33.

The insulating substrate 21 is, for example, a dielectric, such as an aluminum oxide sintered body, an aluminum nitride sintered body, a mullite sintered body or a glass-ceramic sintered body, and can be formed, for example, by stacking ceramic green sheets, which are sheet-shaped layers, on top of one another and firing these.

The first surface conductor 31, the second surface conductor 32 and the electrode pads 34, 35 can be formed by printing metal paste at their positions on ceramic green sheets (the instating substrate 21 before firing) by using a method, such as screen printing, and thereafter firing the metal paste together with the ceramic green sheets. The capacitance sheet conductor 33 can be formed by printing the metal paste at its position on a ceramic green sheet therefor at a stage where the ceramic green sheets, which are the insulating substrate 21 before firing, are separate layers by using a method, such as screen printing, and thereafter stacking the layers of the ceramic green sheets on top of one another and firing all together. As the metal paste, for example, a material in which copper powder is mixed with an organic solvent and an organic binder can be used. The surfaces of the conductors, such as the first surface conductor 31, the second surface conductor 32 and the electrode pads 34, 35, exposed on the insulating substrate 21 may be coated with a plating layer(s) of nickel, cobalt, palladium, gold or the like in order to suppress oxidation corrosion and enhance coupling/joining characteristics of wire bonding.

The short-circuit conductor 41, the capacitance connection conductor 42 and the connection conductors 43, 44 can be formed by making through holes or interlayer holes at their positions on the ceramic green sheets, which are the insulating substrate 21 before firing, filing these with metal paste, and firing the metal paste together with the ceramic green sheets. As the metal paste, for example, a material in which copper powder is mixed with an organic solvent and an organic binder can be used.

According to this configuration, the first surface conductor 31, the second surface conductor 32 and the short-circuit conductor 41 constitute a plate-like inverted-F antenna. The RFID tag IC 50 can transmit and receive radio signals via the plate-like inverted-F antenna. The capacitance sheet conductor 33 faces the second surface conductor 32 to constitute a capacitance. This capacitance makes it possible to downsize the RFID tag device 20A while maintaining characteristics of the plate-like inverted-F antenna.

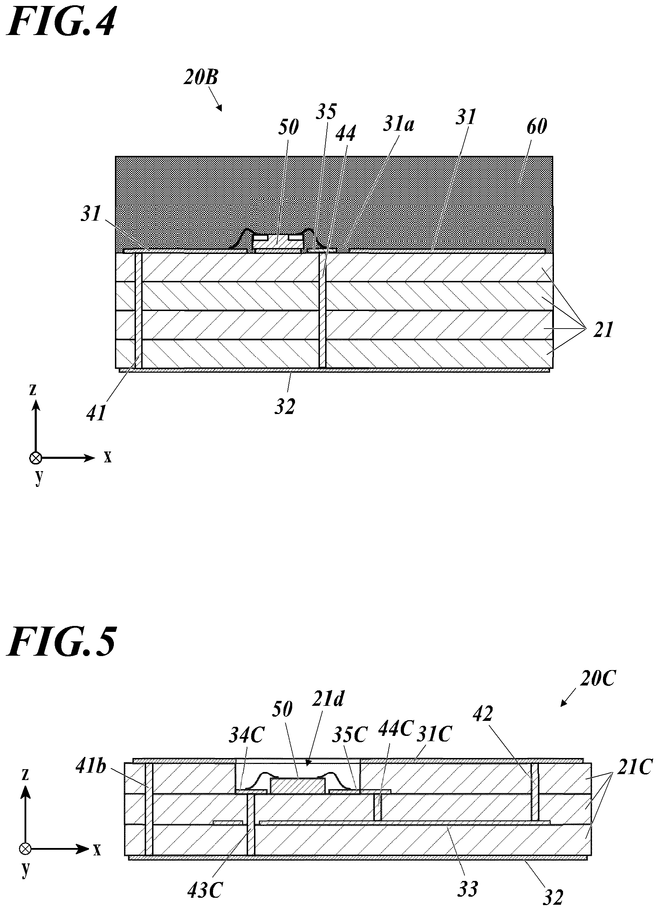

FIG. 4 is a vertical sectional view showing a second example of a representative RFID tag device.

An RFID tag device 20B of the second example is configured by excluding the capacitance sheet conductor 33 from the configuration of the first example. Since the capacitance sheet conductor 33 is not provided, one of the terminals of the RFID tag IC 50 is connected to the first surface conductor 31 via a bonding wire or the like. The electrode pad 35 to which the other of the terminals of the RFID tag IC 50 is connected is electrically connected to the second surface conductor 32 via the connection conductor 44. The insulating substrate 21 and the conductors can be manufactured by the same methods as those described in the first example.

According to this configuration, the first surface conductor 31, the second surface conductor 32 and the short-circuit conductor 41 constitute the plate-like inverted-F antenna. The RFID tag IC 50 can transmit and receive radio signals via the plate-like inverted-F antenna.

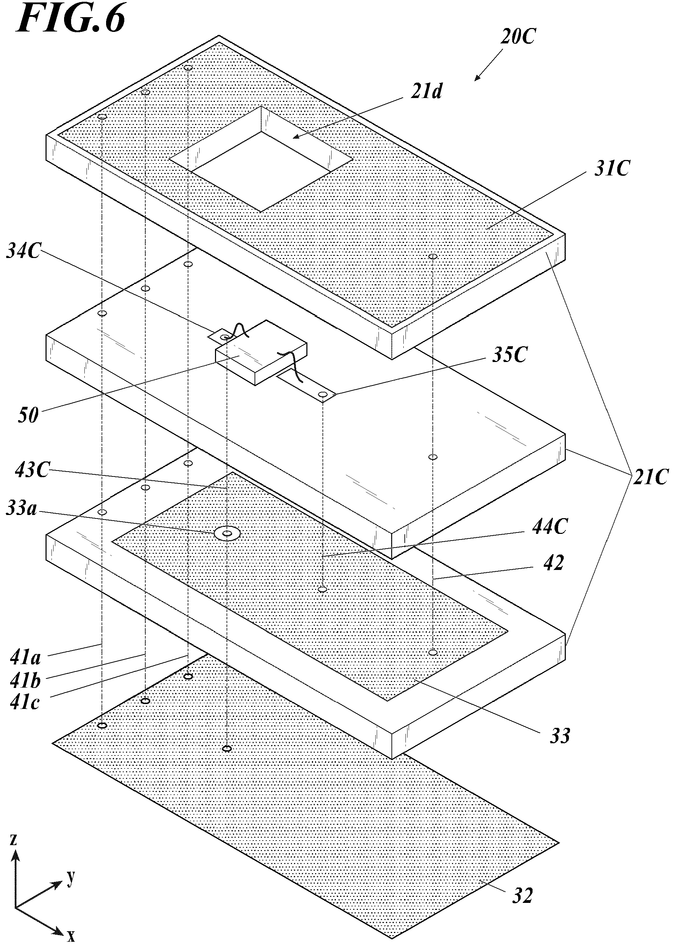

FIG. 5 is a vertical sectional view showing a third example of a representative RFID tag device. FIG. 6 is an exploded perspective view of the RFID tag device shown in FIG. 5. In FIG. 6, short-circuit conductors 41a to 41c, the capacitance connection conductor 42 and connection conductors 43C, 44C are represented by chain lines.

An RFID tag device 20C of the third example includes: an insulating substrate 21C having a cavity structure (recess 21d); a first surface conductor 31C disposed on the first surface of the insulating substrate 21C; the second surface conductor 32 disposed on the second surface of the insulating substrate 21C; and the capacitance sheet conductor 33 located inside the insulating substrate 21C. The first surface conductor 31C, the capacitance sheet conductor 33 and the second surface conductor 32 each extend in the x and y directions. The first surface conductor 31C is located in an area excluding the opening of the recess 21d. On the inner bottom surface of the recess 21d, two electrode pads 34C, 35C that are connected to the terminals of the RFID tag IC 50 are disposed. The electrode pads 34C, 35C may be partly embedded in the insulating substrate 21C. The RFID tag IC 50 is housed in the recess 21d, and its two terminals are connected to the electrode pads 34C, 35C via bonding wires or the like. The recess 21d may be filled with resin mold.

The RFID tag device 20C further includes the short-circuit conductors 41a, 41b, 41c, the capacitance connection conductor 42 and the connection conductors 43C, 44C located inside the insulating substrate 21 and each extending in the z direction. The short-circuit conductors 41a, 41b, 41c are connected to the first surface conductor 31C and the second surface conductor 32 to short-circuit these. The capacitance connection conductor 42 is connected to the first surface conductor 31 and the capacitance sheet conductor 33 to electrically connect these. The connection conductor 43C electrically connects the electrode pad 34 and the second surface conductor 32. The connection conductor 44C electrically connects the electrode pad 35C and the capacitance sheet conductor 33. The connection conductor 43C passes through the through hole 33a of the capacitance sheet conductor 33, and does not contact the capacitance sheet conductor 33.

The insulating substrate 21C and the conductors can be manufactured by the same methods as those described in the first example.

According to this configuration, the first surface conductor 31C, the second surface conductor 32 and the short-circuit conductors 41a, 41b, 41c constitute the plate-like inverted-F antenna. The RFID tag IC 50 connected thereto can transmit and receive radio signals via the plate-like inverted-F antenna. The capacitance sheet conductor 33 faces the second surface conductor 32 to constitute the capacitance. This capacitance makes it possible to downsize the RFID tag device 20C while maintaining characteristics of the plate-like inverted-F antenna.

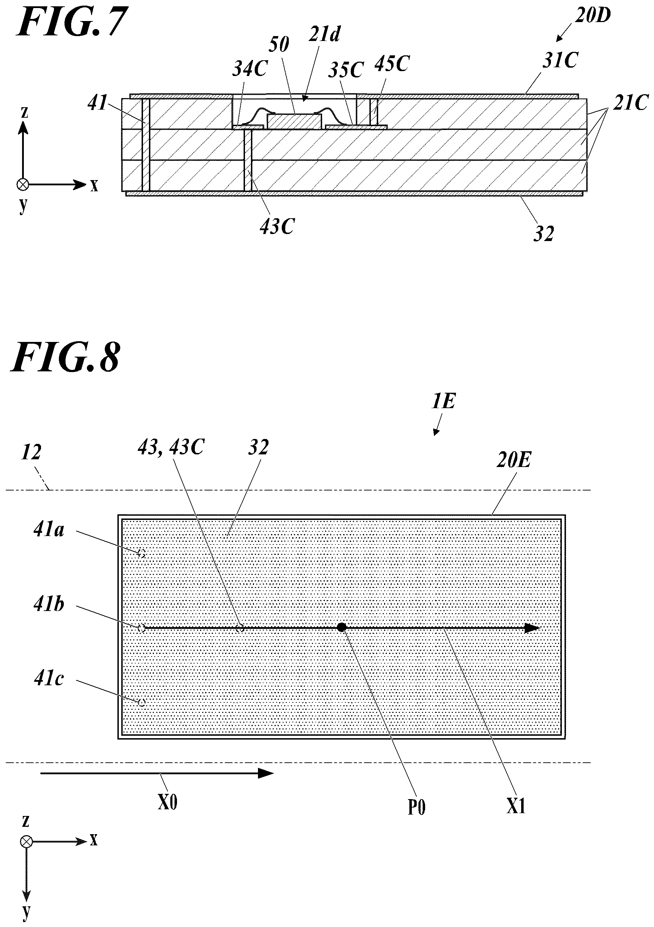

FIG. 7 is a vertical sectional view showing a fourth example of a representative RFID tag device.

An RFID tag device 20D of the fourth example is configured by excluding the capacitance sheet conductor 33 from the configuration of the third example. Since the capacitance sheet conductor 33 is not provided, one of the terminals of the RFID tag IC 50 is electrically connected to the first surface conductor 31C via the electrode pad 35C and a connection conductor 45C. The insulating substrate 21 and the conductors can be manufactured by the same methods as those described in the first example.

According to this configuration, the first surface conductor 31C, the second surface conductor 32 and the short-circuit conductor(s) 41 constitute the plate-like inverted-F antenna. The RFID tag IC 50 connected thereto can transmit and receive radio signals via the plate-like inverted-F antenna.

In the above, four representative examples of the RFID tag device 20 are described. However, the RFID tag device 20 is not limited to the above examples, and has design freedom in some aspects, examples of which include: the position(s) of the short-circuit conductor(s) 41 or 41a to 41c in the x and y directions and the number thereof; the position(s) of the capacitance connection conductor(s) 42 in the x and y directions and the number thereof; the arrangement order of the electrode pads 34/34C and 35/35C in the x direction; the position of the capacitance sheet conductor 33 in the z direction; and the connection destination of the capacitance connection conductor 42, either the first surface conductor 31/31C or the second surface conductor 32. The connection destination of the capacitance connection conductor 42 being the first surface conductor 31/31C means that the combination of the capacitance sheet conductor 33 and the second surface conductor 32 constitutes the capacitance. The connection destination of the capacitance connection conductor 42 being the second surface conductor 32 means that the combination of the capacitance sheet conductor 33 and the first surface conductor 31/31C constitutes the capacitance.

Next, RFID tags 1E to 1M of first to ninth embodiments configured by combining, with the sheet antenna 10, their respective RFID tag devices 20E to 20M in each of which one or more of the above-described aspects having design freedom are specified will be described.

### (First Embodiment)

FIG. 8 is a bottom view of an RFID tag device included in an RFID tag according to a first embodiment.

In an RFID tag 1E of the first embodiment, a first direction X1 of an RFID tag device 20E is aligned with a long side direction X0 (FIG. 1A, FIG. 1B) of the antenna conductor 12 of the seat antenna 10. The RFID tag device 20E is fixed on the sheet antenna 10 such that the first surface conductor 31 or the second surface conductor 32 faces the antenna conductor 12. The RFID tag device 20E may be fixed on the sheet antenna 10 such that the first surface conductor 31 or the second surface conductor 32 is electrically connected to the antenna conductor 12, or is non-electrically connected thereto via (with) an adhesive or the like. Thus, the RFID tag device 20E can be fixed on the sheet antenna 10 in a simple manner, and also their electrical connection is unneeded, so that the reliability of coupling between the RFID tag device 20E and the antenna conductor 12 increases.

The first direction X1 of the RFID tag device 20E is, as shown in FIG. 8, a direction from a connection part(s) in the second surface conductor 32 with the short-circuit conductor (s) 41a, 41b, 41c to the center P0 of the second surface conductor 32. When a plurality of connection parts with the short-circuit conductors 41a to 41c is provided, the first direction X1 means a direction obtained by averaging directions from the connection parts with the respective short-circuit conductors 41a to 41c to the center P0. The first direction X1 thus defined corresponds to a radiation direction of radio signals when the RFID tag device 20E alone is viewed. The long side direction X0 of the antenna conductor 12 means the long side direction of an area of a portion and its periphery facing the RFID tag device 20E.

In this description/specification, that a direction A1 of a first element is aligned with a direction A2 of a second element not only means that the directions A1, A2 perfectly coincide with one another, but also means that a direction A2 component in the direction A1 is larger than an orthogonal component to the direction A2 in the direction A1. Hence, that the first direction X1 of the RFID tag device 20E is aligned with the long side direction X0 of the antenna conductor 12 not only means that these directions perfectly coincide with one another, but also means that a long side direction X0 component in the first direction X1 is larger than a component in a direction perpendicular to the long side direction X0 in the first direction X1. The first direction X1 may be as follows; the first direction X1 ± 30° includes the long side direction X0. The first direction X1 may be as follows; the first direction X1 ± 15° includes the long side direction X0.

A simulation was carried out to calculate antenna gain in the z direction about the first embodiment in which the first direction X1 coincided with the long side direction X0, a form in which the first direction X1 was perpendicular to the long side direction X0, and the RFID tag device 20E alone. The obtained result is shown in COMPARISON TABLE 1.

**[TABLE 1]**

| [COMPARISON TABLE 1] | | | |
|---|---|---|---|
| | RFID TAG | WITH SHEET ANTENNA | |
| STRUCTURE | DEVICE ALONE | X1 COINCIDES WITH X0 | X1 IS PERPENDICULAR TO X0 |
| ANTENNA GAIN | -35 dBi | -11.1 dBi | -30.5 dBi |

The result shown in COMPARISON TABLE 1 indicates that, according to the first embodiment, a relationship between the first direction X1 of the RFID tag device 20E and the long side direction X0 of the antenna conductor 12 enhances the degree of coupling between the plate-like inverted-F antenna of the RFID tag device 20E and the antenna conductor 12 and extends a communicable distance.

### (Second Embodiment)

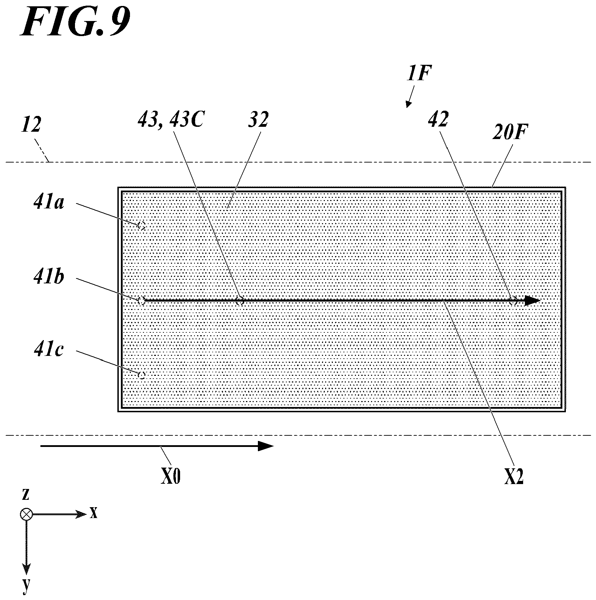

FIG. 9 is a bottom view of an RFID tag device included in an RFID tag according to a second embodiment.

In an RFID tag 1F of the second embodiment, as shown in FIG. 9, a second direction X2 of an RFID tag device 20F is aligned with the long side direction X0 (FIG. 1A, FIG. 1B) of the antenna conductor 12 of the seat antenna 10. The RFID tag device 20F is fixed on the sheet antenna 10 such that the first surface conductor 31 or the second surface conductor 32 faces the antenna conductor 12. The RFID tag device 20F may be fixed on the sheet antenna 10 such that the first surface conductor 31 or the second surface conductor 32 is electrically connected to the antenna conductor 12, or is non-electrically connected thereto via (with) an adhesive or the like. Thus, the RFID tag device 20F can be fixed on the sheet antenna 10 in a simple manner, and also their electrical connection is unneeded, so that the reliability of coupling between the RFID tag device 20F and the antenna conductor 12 increases.

The second direction X2 is a direction from the connection parts in the second surface conductor 32 with the short-circuit conductor(s) 41a, 41b, 41c to a connection part in the second surface conductor 32 with the capacitance connection conductor 42. When a plurality of connection parts with the short-circuit conductors 41a to 41c is provided, or when a plurality of connection parts with capacitance connection conductors 42 is provided, the second direction X2 is a direction obtained by averaging all directions from the connection parts with the respective short-circuit conductors 41a to 41c to the connection part(s) with the capacitance connection conductor(s) 42. The second direction X2 thus defined corresponds to the radiation direction of radio signals when the RFID tag device 20 alone is viewed.

According to this configuration too, the radiation direction of radio signals of the RFID tag device 20F aligned with the long side direction of the antenna conductor 12 enhances the degree of coupling between the plate-like inverted-F antenna of the RFID tag device 20F and the antenna conductor 12 and can extend the communicable distance.

### (Third Embodiment)

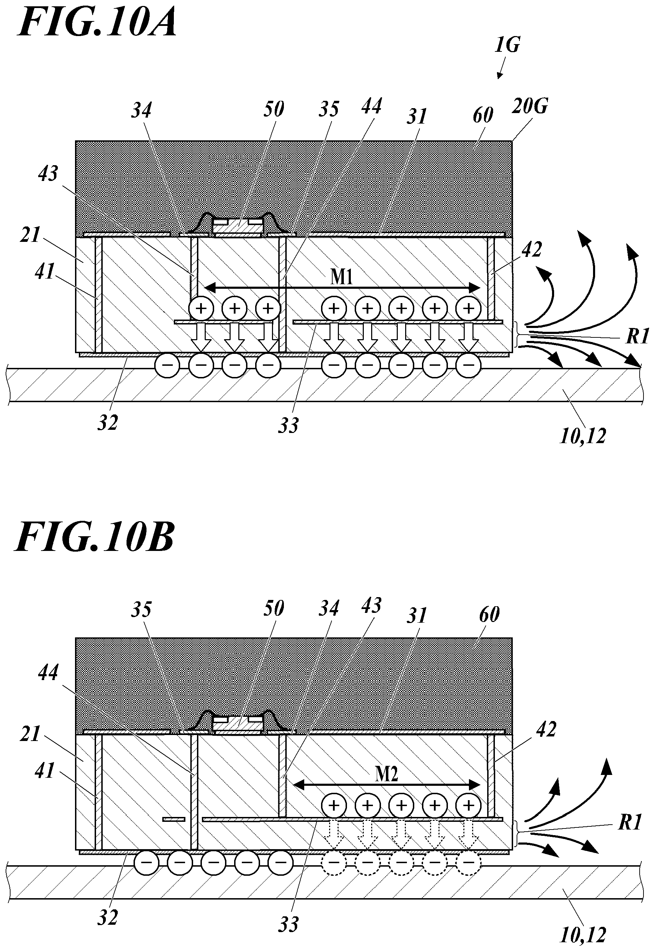

FIG. 10A is a vertical sectional view showing an RFID tag according to a third embodiment. FIG. 10B is a vertical sectional view showing a comparative example against the RFID tag according to the third embodiment. In the example shown in FIG. 10A, the capacitance sheet conductor 33 and the second surface conductor 32 constitute the capacitance, and accordingly the first electrode pad 34 is connected to the capacitance sheet conductor 33 via the connection conductor 43.

An RFID tag 1G of the third embodiment has the same structure as that of the second embodiment, and also has a structure in which the electrode pads 34, 35 of an RFID tag device 20G are arranged as shown in FIG. 10A in relation to the short-circuit conductor(s) 41 and the capacitance connection conductor 42. One of the electrode pads, 35, is connected to the second surface conductor 32 via the connection conductor 44, thereby being distinguished from the other of the electrode pads, 34. Hereinafter, in order to distinguish these two from one another, they may be called the first electrode pad 34 and the second electrode pad 35.

This arrangement of the electrode pads 34, 35 indicates that the distance between the first electrode pad 34 and the short-circuit conductor(s) 41 is shorter than the distance between the second electrode pad 35 and the short-circuit conductor(s) 41. The arrangement also indicates that the distance between the first electrode pad 34 and the capacitance connection conductor 42 is longer than the distance between the second electrode pad 35 and the capacitance connection conductor 42.

A simulation was carried out to calculate the antenna gain in the z direction about the third embodiment (FIG. 10A) and the comparative example (FIG. 10B) in which the arrangement (positions) of the electrode pads 34, 35 was reversed. The obtained result is shown in COMPARISON TABLE 2.

**[TABLE 2]**

| [COMPARISON TABLE 2] | | |
|---|---|---|
| STRUCTURE | ARRANGEMENT OF FIRST ELECTRODE PAD AND SECOND ELECTRODE PAD | |
| | ARRANGEMENT SHOWN IN FIG. 10A | ARRANGEMENT SHOWN IN FIG. 10B |
| ANTENNA GAIN | -7.3 dBi | -11.1 dBi |

Difference in the arrangement of the electrode pads 34, 35 generated difference in the antenna gain. This was caused by the phenomenon described hereinafter. That is, during transmission and reception of radio signals, potential difference between the first electrode pad 34 and the second electrode pad 35 connected to the RFID tag IC 50 becomes large. Hence, in the structure shown in FIG. 10A, a strong electric field is generated between the second surface conductor 32 and the capacitance sheet conductor 33, and strong radio waves radiate from the gap between these two. Radio waves radiate more, of the gap between the second surface conductor 32 and the capacitance sheet conductor 33, from an end R1 near the outer periphery of the RFID tag device 20G. When attention is paid to the second surface conductor 32, on the second surface conductor 32, potential is stable near the connection conductor 44, one end of which is connected to the second electrode pad 35. In the drawings, charges having a high degree of stability are represented by solid lines, and charges having a low degree of stability are represented by broken lines. As compared with the comparative example, in which the second electrode pad 35 is far from the end R1, the third embodiment, in which the second electrode pad 35 is close to the end R1, stabilizes potential of the second surface conductor 32 near the end R1. Thus, as compared with the comparative example, the third embodiment enhances the intensity of radio waves that radiate from the end R1 and enhances the degree of coupling with the antenna conductor 12.

When the RFID tag device 20G shown in FIG. 10A is compared with the comparative example shown in FIG. 10B, since the arrangement of the electrode pads 34, 35 differs, difference is generated in the length between sections M1 and M2. The sections M1, M2 each indicate a section from a connection position on the capacitance sheet conductor 33 with the connection conductor 43 to a connection position on the capacitance sheet conductor 33 with the capacitance connection conductor 42. During operation of the antenna, current mainly flows, of the capacitance (the second surface conductor 32 and the capacitance sheet conductor 33), in the section M1/M2, which is from the connection position with the connection conductor 43 (feed line) to the connection position with the capacitance connection conductor 42. Positive charges and negative charges shown in FIG. 10A and FIG. 10B reverse their polarities in a period depending on the phase of radio signals that are transmitted or received. Hence, of the capacitance (the second surface conductor 32 and the capacitance sheet conductor 33), charges accumulate in the section M1/M2. As the section M1/M2 is longer, more charges accumulate. Accumulation of more charges stabilizes potential difference between the second surface conductor 32 and the capacitance sheet conductor 33 of the capacitance. Hence, as compared with the comparative example shown in FIG. 10B having the short section M2, the RFID tag device 20G having the long section M1 stabilizes the potential difference between the second surface conductor 32 and the capacitance sheet conductor 33 of the capacitance and can radiate radio waves having a higher field intensity.

Thus, according to the RFID tag 1G of the third embodiment, the degree of coupling between the RFID tag device 20G and the antenna conductor 12 is further enhanced, and the wireless communications distance can be further extended.

### (Forth Embodiment)

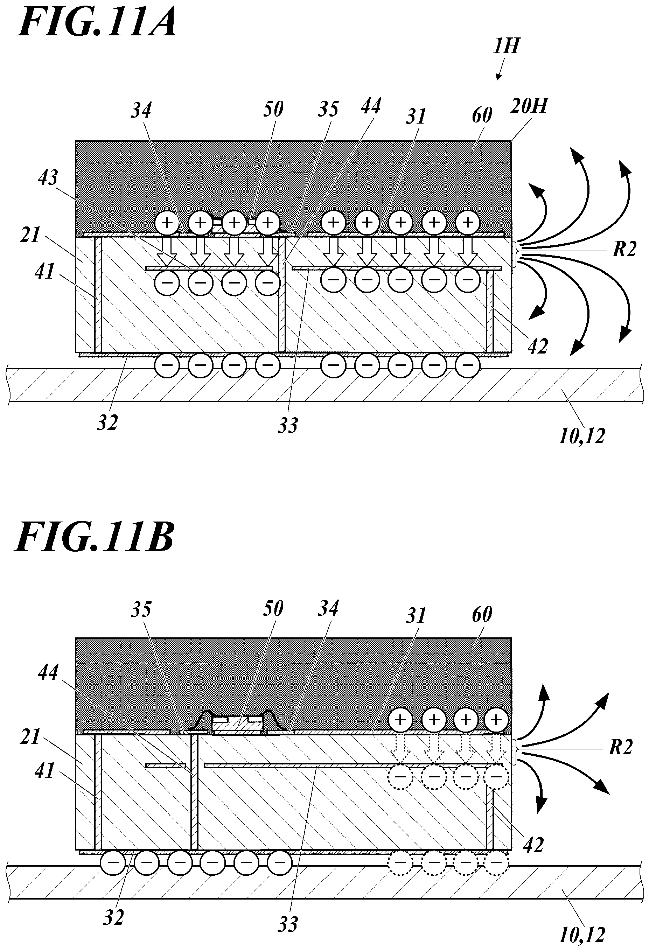

FIG. 11A is a vertical sectional view showing an RFID tag according to a forth embodiment. FIG. 11B is a vertical sectional view showing a comparative example against the RFID tag according to the fourth embodiment.

An RFID tag 1H of the fourth embodiment has the same structure as that of the second embodiment, and also has a structure in which the electrode pads 34, 35 of an RFID tag device 20H are arranged in the same order as that in the third embodiment in relation to the short-circuit conductor(s) 41 and the capacitance connection conductor 42.

The RFID tag device 20H of the fourth embodiment is different from that of the third embodiment in that the capacitance connection conductor 42 is interposed between the capacitance sheet conductor 33 and the second surface conductor 32, and combination of the first surface conductor 31 and the capacitance sheet conductor 33 constitutes the capacitance. In this structure, a strong electric field is generated between the first surface conductor 31 and the capacitance sheet conductor 33, and strong radio waves radiate, of the gap between these two, from an end R2 near the outer periphery of the RFID tag device 20G.

According to this configuration too, the arrangement of the electrode pads 34, 35 shown in FIG. 11A stabilizes the potential of the second surface conductor 32 and the capacitance sheet conductor 33 in an area near the end R2, from which radio waves radiate, and can enhance the intensity of radio waves that radiate from the end R2. Thus, according to the RFID tag 1H of the fourth embodiment, as with the third embodiment, the degree of coupling between the RFID tag device 20H and the antenna conductor 12 is further enhanced, and the wireless communications distance can be further extended.

### (Fifth Embodiment)

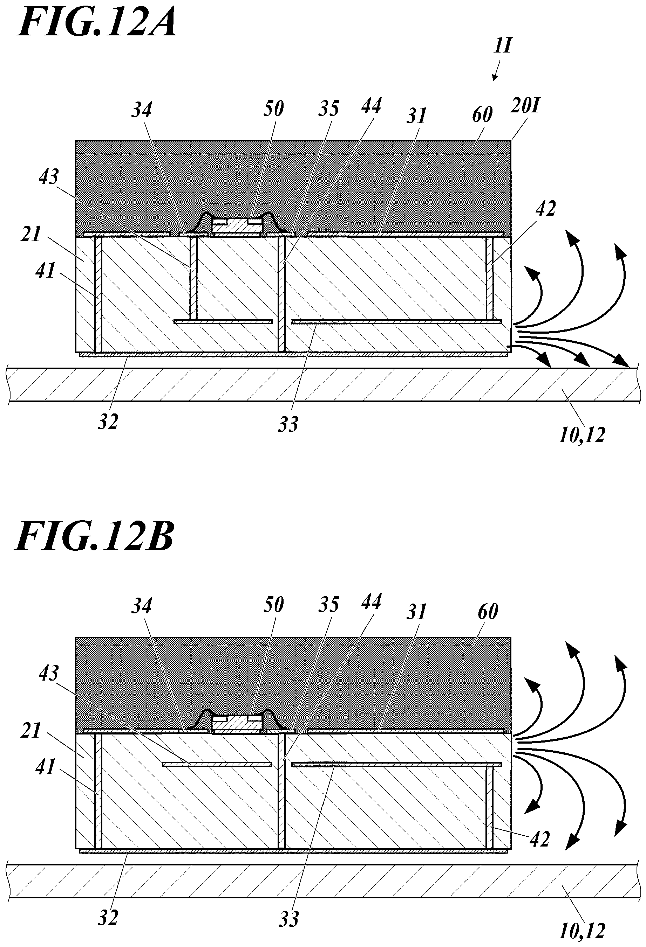

FIG. 12A is a vertical sectional view showing an RFID tag according to a fifth embodiment. FIG. 12B is a vertical sectional view showing a comparative example against the RFID tag according to the fifth embodiment.

An RFID tag 1I of the fifth embodiment has the same structure as that of the second embodiment, and also has a structure in which the second surface conductor 32 side of the insulating substrate 21 faces the sheet antenna 10, and the capacitance connection conductor 42 connects the first surface conductor 31 and the capacitance sheet conductor 33. That is, combination of the second surface conductor 32 and the capacitance sheet conductor 33 constitute the capacitance.

In the specific example shown in FIG. 12A, the electrode pads 34, 35 are arranged in the same manner as that in the third embodiment. In the fifth embodiment, however, the arrangement of the electrode pads 34, 35 may be reversed.

A simulation was carried out to calculate the antenna gain in the z direction about the fifth embodiment (FIG. 12A) and the comparative example (FIG. 12B) in which the capacitance connection conductor 42 was connected to the second surface conductor 32. The obtained result is shown in COMPARISON TABLE 3. In the structure shown in FIG. 12B, combination of the first surface conductor 31 and the capacitance sheet conductor 33 constitute the capacitance.

**[TABLE 3]**

| **[COMPARISON TABLE 3]** | | |
|---|---|---|
| **STRUCTURE** | **SURFACE/SHEET CONDUCTORS CONSTITUTING CAPACITANCE** | |
| | **CAPACITANCE SHEET CONDUCTOR AND SECOND SURFACE CONDUCTOR (****FIG. 12A****)** | **FIRST SURFACE CONDUCTOR AND CAPACITANCE SHEET CONDUCTOR (****FIG. 12B****)** |
| **ANTENNA GAIN** | **-7.3 dBi** | **-8.3 dBi** |

As described above, radio waves radiate with a high field intensity from a gap between two surface conductors constituting a capacitance to the outside. Hence, as compared with the comparative example shown in FIG. 12B, the configuration shown in FIG. 12A, in which the second surface conductor 32 constitutes a part of the capacitance, radiates radio waves having a high field intensity from the vicinity of the antenna conductor 12. Thus, according to the RFID tag 1I of the fifth embodiment, as compared with the comparative example shown in FIG. 12B, a high degree of coupling between the RFID tag device 201 and the seat antenna 10 is obtained, and the wireless available distance can be further extended.

Further, according to the RFID tag 1I of the fifth embodiment, the RFID tag device 201 and the antenna conductor 12 are firmly coupled. Hence, even when a difference is generated in the distance between the second surface conductor 32 and the antenna conductor 12 by, for example, the thickness of an adhesive, the shift of the resonant peak frequency of the antenna after the coupling can be suppressed. For this reason too, according to the RFID tag 1I of the fifth embodiment, the wireless available distance can be further extended.

### (Sixth Embodiment)

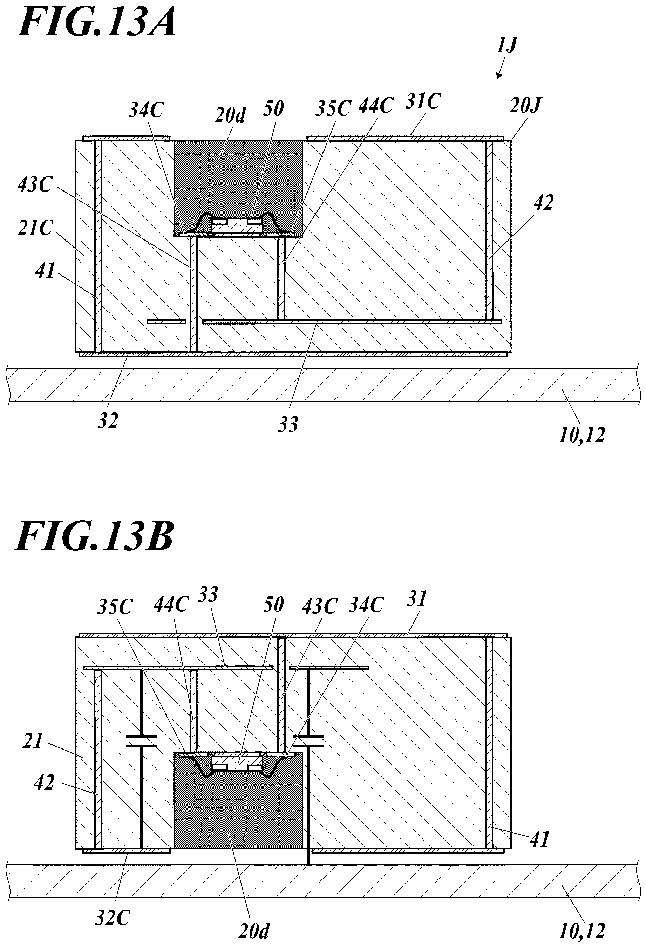

FIG. 13A is a vertical sectional view showing an RFID tag according to a sixth embodiment. FIG. 13B is a vertical sectional view showing a comparative example against the RFID tag according to the sixth embodiment.

An RFID tag 1J of the sixth embodiment has the same structure as that of the first embodiment or the second embodiment, and also has a structure in which an RFID tag device 20J has a cavity structure, and the recess 21d is disposed opposite the seat antenna 10. In the sixth embodiment, the arrangement order of electrode pads 34C, 35C is not limited to that shown in FIG. 13A, and may be reversed.

A simulation was carried out to calculate how much the resonant peak frequency of the antenna was shifted when the RFID tag device 20J was fixed with a gap between the RFID tag device 20J and the sheet antenna 10 changed. The obtained result is shown in COMPARISON TABLE 4. In the simulation, the shift amount of the resonant peak frequency was calculated about the sixth embodiment (FIG. 13A) and the configuration (FIG. 13B) in which the recess 21d was disposed on the sheet antenna 10 side. In the comparative example (FIG. 13B), the surface conductor on the recess 21d side is referred to as a second surface conductor 32C, and the surface conductor on the opposite side to the recess 21d is referred to as the first surface conductor 31. A case where the gap between the RFID tag device 20J and the sheet antenna 10 was 0.3 mm and a case where the gap was 0.05 mm were compared with one another.

**[TABLE 4]**

| **[COMPARISON TABLE 4]** | | |
|---|---|---|
| **STRUCTURE** | **RECESS DISPOSED ON OPPOSITE SIDE TO SHEET ANTENNA** | **RECESS DISPOSED ON SHEET ANTENNA SIDE** |
| **SHIFT AMOUNT OF RESONANT PEAK FREQUENCY** | **1 MHz** | **3 MHz** |

Difference in the shift amount of the resonant peak frequency was generated for the reasons described hereinafter. In the comparative example, the distance between the capacitance sheet conductor 33 and a reference plane as a ground potential in the plate-like inverted-F antenna is, at a portion where the recess 21d is not present, the distance between the capacitance sheet conductor 33 and the second surface conductor 32C, but at a portion where the recess 21d is present, the distance between the capacitance sheet conductor 33 and the antenna conductor 12. Hence, when a difference is present in the gap between the RFID tag device 20J and the sheet antenna 10 due to the thickness of an adhesive or the like, at the portion where the recess 21d is present, the distance between the capacitance sheet conductor 33 and the reference plane changes, and this appears as the shift of the resonant peak frequency of the antenna. On the other hand, in the sixth embodiment, the distance between the capacitance sheet conductor 33 and the reference plane as the ground potential in the plate-like inverted-F antenna is the distance between the capacitance sheet conductor 33 and the second surface conductor 32, and does not differ between the portion where the recess 21d is present and the portion where the recess 21d is not present. Hence, even when a difference is present in the gap between the RFID tag device 20J and the sheet antenna 10, the shift of the resonant peak frequency of the antenna is suppressed. The shift of the resonant peak frequency leads to decrease in the intensity of radio signals in wireless communications where the frequency is constant, and hence is a factor in shortening the communicable distance. Thus, according to the RFID tag 1J of the sixth embodiment, since the shift of the resonant peak frequency is small, the intensity of radio signals is stabilized, and reduction of the communicable distance can be suppressed.

In the sixth embodiment, the capacitance sheet conductor 33 is provided, but even when the capacitance sheet conductor 33 is not provided, the distance between the first surface conductor 31 and the reference plane is unchanged between the portion where the recess 21d is present and the portion where the recess 21d is not present. Hence, as compared with the comparative example, in which the recess 21d is disposed on the sheet antenna 10 side, the intensity of radio signals is stabilized, and reduction of the communicable distance can be suppressed. That is, the same effects as the above are obtained.

### (Seventh Embodiment)

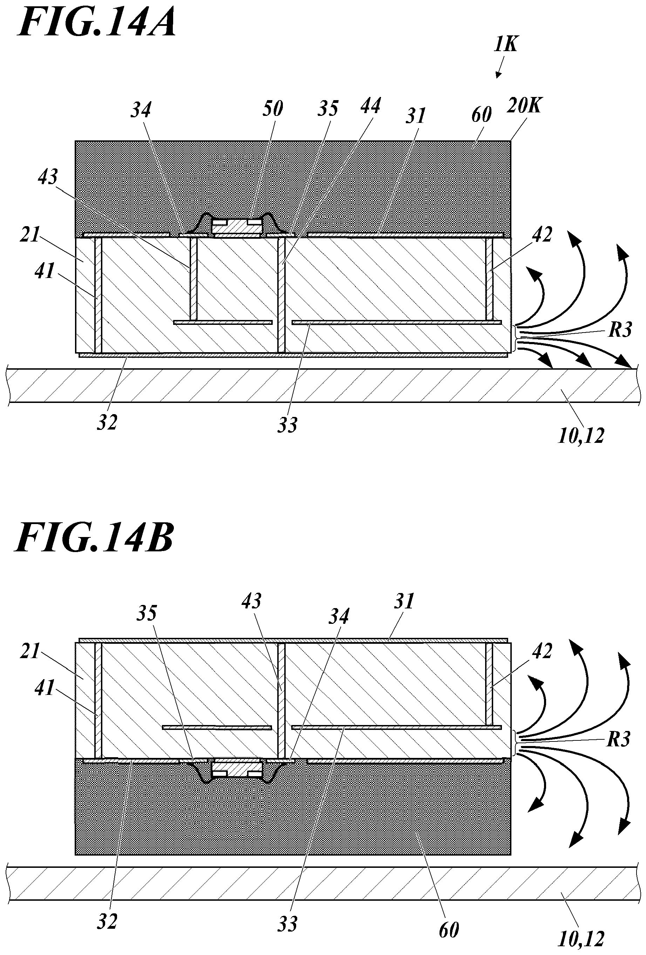

FIG. 14A is a vertical sectional view showing an RFID tag according to a seventh embodiment. FIG. 14B is a vertical sectional view showing a comparative example against the RFID tag according to the seventh embodiment.

An RFID tag 1K of the seventh embodiment has the same structure as that of the first embodiment or the second embodiment, and also has a structure in which an RFID tag device 20K has the molded resin 60 on one side, and the molded resin 60 is disposed opposite the sheet antenna 10. In the seventh embodiment, the arrangement order of the electrode pads 34, 35 is not limited to that shown in FIG. 14A, and may be reversed.

A simulation was carried out to calculate the antenna gain in the z-direction about the seventh embodiment (FIG 14A) and the configuration (FIG 14B) in which the molded resin 60 was disposed on the sheet antenna 10 side. The obtained result is shown in COMPARISON TABLE 5.

**[TABLE 5]**

| **[COMPARISON TABLE 5]** | | |
|---|---|---|
| **STRUCTURE** | **MOLDED RESIN DISPOSED ON OPPOSITE SIDE TO SHEET ANTENNA** | **MOLDED RESIN DISPOSED ON SHEET ANTENNA SIDE** |
| **ANTENNA GAIN** | **-7.3 dBi** | **-10.3 dBi** |

As described above, radio waves radiate with a high field intensity from a gap between surface conductors (the first surface conductor 31, the second surface conductor 32, the capacitance sheet conductor 33) to the outside. In the comparative example shown in FIG. 14B, due to the interposition of the molded resin 60, the distance between an end R3 of the RFID tag device 20K from which radio waves radiate and the antenna conductor 12 of the sheet antenna 10 is long, and the degree of coupling between these decreases. On the other hand, in the seventh embodiment shown in FIG. 14A, the end R3 of the RFID tag device 20K from which radio waves radiate is near the antenna conductor 12 of the seat antenna 10, and the degree of coupling between these increases. Thus, according to the RFID tag 1K of the seventh embodiment, a high degree of coupling between the RFID tag device 20K and the seat antenna 10 is obtained, and the wireless available distance can be further extended.

### (Eighth Embodiment)

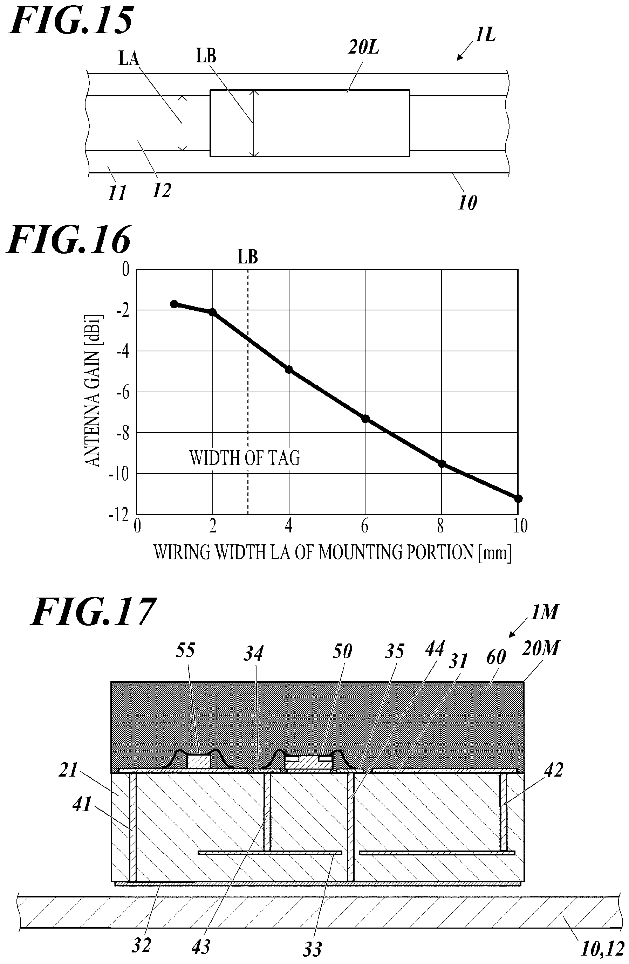

FIG. 15 is a plan view showing an RFID tag according to an eighth embodiment. FIG. 16 is a graph showing a relationship between the wiring width of an antenna conductor and the antenna gain.

An RFID tag 1L of the eighth embodiment has the same structure as that of the first embodiment or the second embodiment, and also has a structure in which the wiring width LA of a mounting portion where an RFID tag device 20L is mounted of the antenna conductor 12 in the short side direction is smaller than the width LB of the second surface conductor 32 in the same direction.

A simulation in which the wiring width LA of the mounting portion of the antenna conductor 12 was changed was carried out to calculate the antenna gain in the z direction. The obtained simulation result is shown in FIG. 16. This simulation result shows that as the wiring width LA is smaller than the width LB of the second surface conductor 32, the antenna gain is higher. This change in the antenna gain was caused by the following; when the wiring width LA is smaller, radio waves that travel from the RFID tag device 20L to the opposite surface of the antenna conductor 12 via the both edges of the antenna conductor 12 in the short side direction increase.

As described above, according to the RFID tag 1L of the eighth embodiment, the wiring width LA of the antenna conductor 12 smaller than the width LB of the second surface conductor 32 enhances the degree of coupling between the RFID tag device 20L and the antenna conductor 12 and can further extend the wireless available distance.

### (Ninth Embodiment)

FIG. 17 is a vertical sectional view showing an RFID tag according to a ninth embodiment.

An RFID tag 1M of the ninth embodiment has any one of the structures of the first to eighth embodiments, and also has a structure in which a sensor 55 that detects a predetermined physical quantity is mounted in an RFID tag device 20M. As the sensor 55, there are various applicable sensors, examples of which include a temperature sensor, an acceleration sensor and a pressure sensor. The sensor 55 may be connected to the RFID tag IC 50 so as to output detection values thereto, and the detection values by the sensor 55 may be stored, of the RFID tag IC 50, in a memory from which data is readable by an external reader/writer.

According to the RFID tag 1M of the ninth embodiment, an effect of reading a predetermined physical quantity of the surrounding environment with an external reader/writer can be obtained.

In the above, several embodiments are described. However, the present invention is not limited to the above embodiments. For example, a structure in which any two or more of combinable features among the features of the first to ninth embodiments are combined may be employed. Further, in the first to fifth, eighth and ninth embodiments, as the RFID tag devices 20E to 201, 20L and 20M, a type of RFID tag device having one side filled with the molded resin 60 is used, but as the RFID tag devices 20E to 201, 20L and 20M of the first to fifth, eighth and ninth embodiments, a type of RFID tag device having a cavity structure may be used. Further, in the above embodiments, the RFID tags 1 and 1E to 1M are configured to operate by receiving electric power from a reader/writer, but may have a built-in cell/battery and perform wireless communications by electric power of the cell/battery. Further, the details described in the embodiments can be appropriately modified within a range not departing from the scope of the invention.

### (Tenth Embodiment)

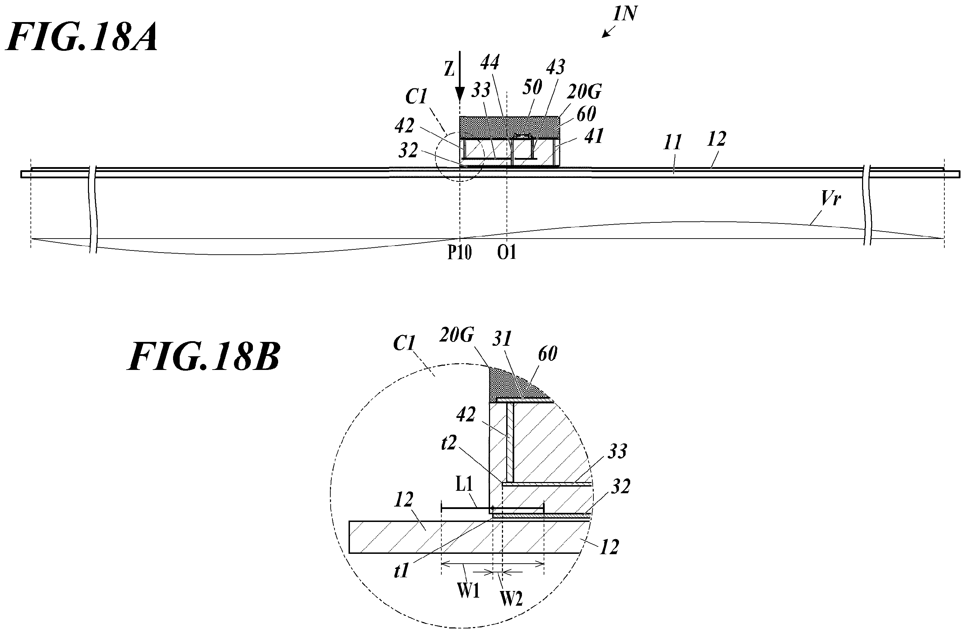

FIG. 18A shows an RFID tag according to a tenth embodiment. FIG. 18B is an enlarged view of an area C1 shown in FIG. 18A.

In an RFID tag 1N according to the tenth embodiment, the position of the RFID tag device 20G with respect to the antenna conductor 12 is specified. FIG. 18A shows, as a representative configuration example, an example in which the RFID tag device 20G shown in FIG. 10A is employed. However, as the RFID tag device, any one of the RFID tag devices 20A to 20K and 20M shown in FIG. 2 to FIG. 10A, FIG. 11A, FIG. 12A, FIG. 13A, FIG. 14A and FIG. 17, or a configuration accompanied with any one of the modifications described in the above embodiments may be employed.

When the RFID tag 1N of the tenth embodiment is viewed in a direction Z, the position P10 of a node of a resonant radio wave voltage Vr on the antenna conductor 12 is located opposite the short-circuit conductor(s) 41 across the center O1 of the second surface conductor 32.

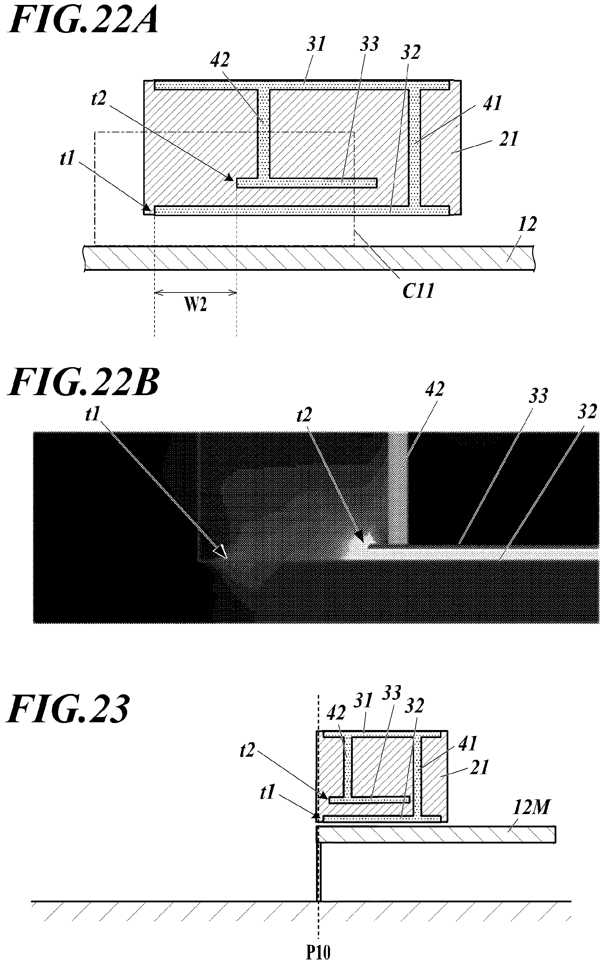

The direction Z is a direction in which the antenna conductor 12 and the second surface conductor 32 face one another. The position P10 of the node corresponds to the center point of the antenna conductor 12 in the long side direction when the antenna conductor 12 is a dipole antenna. The antenna conductor is not limited to having a long straight shape, and may be shaped into a long meandering path. In this case, the center point of the antenna conductor corresponds to the position of the center in the distance along the meandering path. As shown in FIG. 23, an antenna conductor 12M may be a monopole antenna. In this case, the position P10 of the node corresponds to a grounding point.

Further, when the RFID tag 1N of the tenth embodiment is viewed in the direction Z, the position P10 of the node of the antenna conductor 12 may be located in an area W1 with an end t1 of the second surface conductor 32 as the center (FIG. 18B). The end t1 is an end of the second surface conductor 32 opposite the short-circuit conductor(s) 41, and the length of the area W1 corresponds to one-fourth of the length L1 of the second surface conductor 32 in the long side direction.

Further, when the RFID tag 1N of the tenth embodiment is viewed in the direction Z, the position P10 of the node of the antenna conductor 12 may be located in an area W2 from the end t1 of the second surface conductor 32 opposite the short-circuit conductor(s) 41 to an end t2 of the capacitance sheet conductor 33 opposite the short-circuit conductor(s) 41 (FIG. 18B).

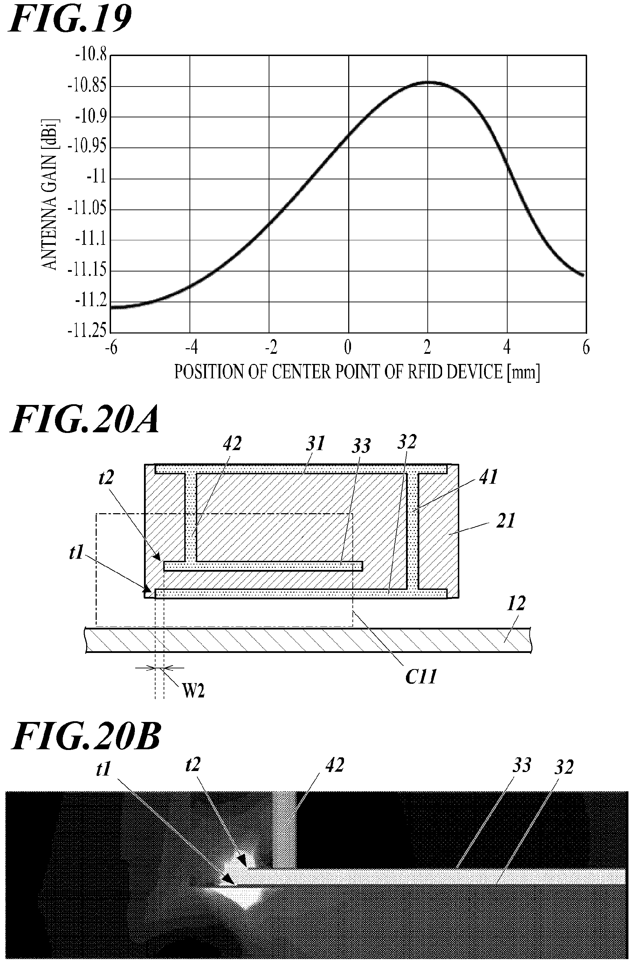

FIG. 19 is a graph showing a relationship between the position of the RFID tag device and the antenna gain. This graph shows the antenna gain obtained by a simulation in which the position of the RFID tag device 20G was shifted. As shown in FIG. 19, when the center point of the RFID tag device 20G is shifted to one side across the position P10 of the node of the antenna conductor 12, high antenna gain is obtained. In the simulation, the calculation was carried out about the RFID tag device 20G having 5 mm as a dimension in the long side direction, and 2 mm or around at which the local maximum point of the antenna gain appears indicates that the end of the RFID tag device 20G opposite the short-circuit conductor(s) 41 is arranged at or around the position P10 of the node.

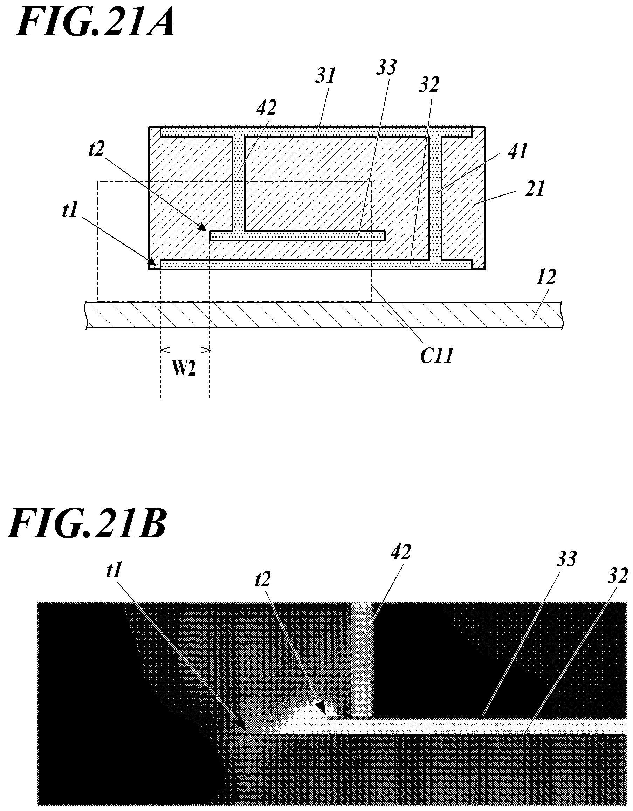

FIG. 20A, FIG. 21A and FIG. 22A show three reference examples of RFID tag devices. FIG. 20B, FIG. 21B and FIG. 22B show the field intensity at the end opposite the short-circuit conductor(s) in the respective RFID tag devices of the three reference examples. FIG. 20A, FIG. 21A and FIG. 22A each show a positional relationship between predetermined conductors of the RFID tag device, wherein the RFID tag IC 50 and the connection conductors 43, 44 are omitted. FIG. 20B, FIG. 21B and FIG. 22B show simulation results of the field intensity in an area C1 shown in FIG. 20A, FIG. 21A and FIG. 22A, respectively, wherein lighter portions represent higher field intensities.

The RFID tag devices of three forms shown in FIG. 20A, FIG. 21B and FIG. 22B are different from one another in distance (the length of the area W2) between the end t1 of the second surface conductor 32 (the end t1 opposite the short-circuit conductor(s) 41) and the end t2 of the capacitance sheet conductor 33 (the end t2 opposite to the short-circuit conductor (s) 41). As shown in FIG. 20B, FIG. 21B and FIG. 22B, in the configuration having the capacitance sheet conductor 33, a strong electric field is generated between the capacitance sheet conductor 33 and the second surface conductor 32. The strong electric field is output from the opening between the end t1 of the second surface conductor 32 and the end t2 of the capacitance sheet conductor 33. As shown in FIG. 20B, FIG. 21B and FIG. 22B, on the antenna conductor 12 side too, in the area W2 between the end t1 of the second surface conductor 32 and the end t2 of the capacitance sheet conductor 33, the strong electric field is output.

As described above, according to the RFID tag 1N of the tenth embodiment, as indicated by the simulation results shown in FIG. 19, FIG. 20B, FIG. 21B and FIG. 22B, the position P10 of the node of the antenna conductor 12 adjusted to the opposite side to the short-circuit conductor(s) 41 can achieve high antenna gain. Further, the position P10 of the node of the antenna conductors 12 adjusted to the area W1 or the area W2 shown in FIG. 18B can achieve higher antenna gain. As shown in FIG. 23, even when a monopole antenna is employed, an RFID tag device arranged in the same manner as the above with respect to the position P10 of the node of the antenna conductor 12M can achieve high antenna gain.

In the above, the tenth embodiment of the present disclosure is described. However, the present invention is not limited to the above embodiment. For example, in the tenth embodiment, the RFID tag device has the capacitance sheet conductor, but even when it does not have the capacitance sheet conductor, a strong electric field is output from the gap between the first surface conductor and the second surface conductor on the opposite side to the short-circuit conductor(s) 41. Hence, employment of the configuration in which the position of the node of the antenna conductor is adjusted to the opposite side to the short-circuit conductor(s) or the configuration in which the position of the node of the antenna conductor is adjusted to the area W1 can achieve high antenna gain. Further, the details described in the embodiment can be appropriately modified within a range not departing from the scope of the invention.

### Industrial Applicability

The present disclosure is applicable to an RFID tag.

## Claims

1. An RFID tag comprising:
an RFID tag device including an RFID tag IC and a board where the RFID tag IC is mounted; and
a seat antenna to which the RFID tag device is fixed, the seat antenna including an antenna conductor,
wherein the board includes:
a first surface conductor;
a second surface conductor disposed between the first surface conductor and the antenna conductor; and
a short-circuit conductor short-circuiting the first surface conductor and the second surface conductor, and
wherein a direction from a connection part in the second surface conductor with the short-circuit conductor to a center of the second surface conductor is aligned with a long side direction of the antenna conductor.

2. The RFID tag according to claim 1,
wherein the board further includes:
a capacitance sheet conductor disposed between the first surface conductor and the second surface conductor; and
a capacitance connection conductor electrically connecting the capacitance sheet conductor to the first surface conductor or the second surface conductor, and
wherein a direction from the short-circuit conductor to the capacitance connection conductor is aligned with the long side direction of the antenna conductor.

3. The RFID tag according to claim 2,
wherein the board includes: a first electrode to which a first terminal of the RFID tag IC is connected and that is electrically connected to the first surface conductor or the capacitance sheet conductor; and a second electrode to which a second terminal of the RFID tag IC is connected and that is electrically connected to the second surface conductor, and
wherein a distance between the first electrode and the short-circuit conductor is shorter than a distance between the second electrode and the short-circuit conductor, and a distance between the first electrode and the capacitance connection conductor is longer than a distance between the second electrode and the capacitance connection conductor.

4. The RFID tag according to claim 2 or 3,
wherein the capacitance connection conductor is connected to the first surface conductor and the capacitance sheet conductor, and
wherein combination of the second surface conductor and the capacitance sheet conductor constitutes a capacitance.

5. The RFID tag according to any one of claims 1 to 4,
wherein the board has a recess where the RFID tag IC is housed, and
wherein an opening of the recess faces an opposite side to the antenna conductor.

6. The RFID tag according to any one of claims 1 to 4,
wherein the board includes a molded resin in which the RFID tag IC is embedded, and
wherein the molded resin is disposed opposite the antenna conductor.

7. The RFID tag according to any one of claims 1 to 6, wherein a width dimension of at least a portion of the antenna conductor in a short side direction is smaller than a width dimension of the second surface conductor in the short side direction, the portion facing the board.

8. The RFID tag according to any one of claims 1 to 7, further comprising a sensor that is mounted in the board and detects a predetermined physical quantity.

9. An RFID tag comprising:
an RFID tag device including an RFID tag IC and a board where the RFID tag IC is mounted; and
an antenna conductor,
wherein the board includes:
a first surface conductor disposed opposite the antenna conductor;
a second surface conductor that faces the antenna conductor; and
a short-circuit conductor that short-circuits the first surface conductor and the second surface conductor, and
wherein when the RFID tag is viewed in a direction in which the second surface conductor and the antenna conductor face one another, a position of a node of a resonant radio wave voltage on the antenna conductor is located opposite the short-circuit conductor across a center of the second surface conductor.

10. The RFID tag according to claim 9, wherein the position of the node of the resonant radio wave voltage is a center of the antenna conductor when the antenna conductor is a dipole antenna, and is a grounding point when the antenna conductor is a monopole antenna.

11. The RFID tag according to claim 9 or 10, wherein when the RFID tag is viewed in the direction in which the second surface conductor and the antenna conductor face one another, the position of the node of the resonance radio wave voltage on the antenna conductor is located in an area with an end of the second surface conductor opposite the short-circuit conductor as a center, the area having a length that is one-fourth of a length of the second surface conductor in a long side direction.

12. The RFID tag according to claim 9 or 10, wherein the board includes a capacitance sheet conductor between the first surface conductor and the second surface conductor, and
wherein when the RFID tag is viewed in the direction in which the second surface conductor and the antenna conductor face one another, the position of the node of the resonant radio wave voltage on the antenna conductor is located in an area from an end of the second surface conductor opposite the short-circuit conductor to an end of the capacitance sheet conductor opposite the short-circuit conductor.
